# EUROPEAN PATENT APPLICATION

(11) **EP 3 460 091 A1**
(43) Date of publication of application: **27.03.2019**
(21) Application number: 17799611.3
(22) Date of filing: 16.05.2017
(51) Int. Cl.: C23C 4/00, C23C 4/12, C23C 14/24

(54) **MOLTEN MATERIAL SUPPLY UNIT AND DRY COATING DEVICE COMPRISING SAME**

(30) Priority: 16.05.2016 KR 20160059788
(71) Applicant: Posco, Pohang-si, Gyeongsangbuk-do 37859 (KR)
(72) Inventor: KIM, Goo-Hwa, Pohang-si Gyeongsangbuk-do 37877 (KR); LIM, Seung-Ho, Pohang-si Gyeongsangbuk-do 37877 (KR); KIM, Tae-Yeob, Gwangyang-si Jeollanam-do 57807 (KR); PARK, Yeong-Seon, Gwangyang-si Jeollanam-do 57807 (KR); NAM, Kyung-Hoon, Gwangyang-si Jeollanam-do 57807 (KR)
(74) Representative: Zech, Stefan Markus
(86) International application number: PCT/KR2017/005039
(87) International publication number: WO 2017/200253

(57) **Abstract**

A molten material supply unit according to an embodiment of the present invention may comprise: a raw material supply portion to which a solid material is fed; a melting container portion connected to the raw material supply portion so as to melt the solid material, thereby forming a molten material, and to discharge the molten material to the outside; and a barrier portion provided between a supply area of the melting container portion, which is connected to the raw material supply portion, and a discharge area of the melting containing portion, through which the molten material is discharged to the outside, such that the molten material is solely moved to the discharge area. In addition, a dry coating device according to another embodiment of the present invention may comprise: the molten material supply unit; a vacuum chamber unit provided such that a-to-be-plated member can move therein, the melting container portion of the molten material supply unit being provided inside the vacuum chamber unit; and a vapor spraying unit provided inside the vacuum chamber unit and connected to the melting container portion so as to heat the molten material, thereby forming a vapor material, and to spray the vapor material to the to-be-plated member, thereby coating the same.

## Description

### [Technical Field]

The present disclosure relates to a molten material supply unit, and a dry coating device comprising the same.

### [Background Art]

Coating materials, such as a gaseous metal, may be coated on a surface of a steel sheet through various known methods of depositing a steel sheet to be continuously progress in a vacuum atmosphere. In vacuum deposition using such a dry plating method, a solid or a liquid coating material (e.g., a metal or a coating material) is evaporated by being heated in a vacuum atmosphere to form a gas, and a thin film is formed on the steel sheet by the gas.

More specifically, in a conventional dry coating method, an electromagnetic coil for heating a coating material is disposed in a vacuum chamber through which a member to be plated, such as a steel sheet, continuously passes; and a supplied solid or liquid coating material may be heated by electromagnetic force generated upon the application of a high frequency current on an internal side of the electromagnetic coil to produce a coating gas, for example, a gaseous metal, and the resulting coating gas is deposited on the steel sheet through an induction means and a spraying means to carry out a coating operation thereon.

Such a dry plating technique is widely used in various industries since excellent characteristics of a plated layer even in a relatively thin plating thickness may be obtained, compared with a wet plating technique. However, in this regard, there are still limitations in a continuous and massive production, since a vacuum state should be maintained.

For example, in order to form a plated layer on a product to be manufactured in a relatively high speed, a large amount of evaporation source material should be melted and evaporated within a unit time, and a relatively long time of continuous plating operations may be required for a large-scale production. Therefore, there is a limit to supplying a raw material of an evaporation source to the evaporator at a relatively high speed and in a continuous manner.

In this case, in order to achieve the above-mentioned continuous supply of raw materials, conventionally, there has been proposed a method of supplying raw materials in wire form or supplying raw materials in liquid form, or the like. However, when the raw material in wire form is used, there may be a problem that total costs are increased by adding a processing cost for processing the raw material into the wire form. Further, when the raw material in liquid form is used, all the raw materials of exposed liquid should be maintained at a relatively high temperature, and there is a limit to the use of a valve for controlling the supply amount of the high temperature liquid raw material. Therefore, there may be a problem that costs for operations and facilities are greatly increased.

Particularly, when the coating operation is performed by forming a coating gas using a solid raw material, there may be a problem that the solid raw material is difficult to be continuously supplied, in view of the fact that the coating gas flows backwards along a connection pipe for supplying the solid raw material.

Therefore, there is a need to study a molten material supply unit, and a dry coating device comprising the same for solving the above-mentioned problems.

### [Disclosure]

### [Technical Problem]

An aspect of the present disclosure may provide a molten material supply unit, and a dry coating device comprising the same, capable of continuously charging a plated material for performing a dry plating operation without processing the plated material into wire form or injecting the plated material in liquid form.

### [Technical Solution]

According to an aspect of the present disclosure, a molten material supply unit includes a raw material supply portion to which a solid material is supplied; a melting container portion connected to the raw material supply portion, and configured to melt the solid material to form a liquefied material and then emit the liquefied material externally; and a barrier portion provided between a supply area of the melting container portion connected to the raw material supply portion and an emission area of the melting container portion emitting the liquefied material externally, and configured to move only the liquefied material to the emission area.

In the molten material supply unit according to an aspect of the present disclosure, the barrier portion may include a wall member provided between the supply area, one side of the melting container portion, and the emission area, the other side of the melting container portion, to separate an upper end portion of the supply area from an upper end portion of the emission area; and a through hole provided in a lower end portion of the wall member.

In the molten material supply unit according to an aspect of the present disclosure, the melting container portion may include a container member having a supply port formed on one side of the melting container portion and connected to the raw material supply portion, and an emission port formed on the other side of the melting container portion and emitting the liquefied material externally; and a melting heater provided in the container member and melting the solid material.

In the molten material supply unit according to an aspect of the present disclosure, the melting container portion may further include a pressure adjuster provided in the container member, and configured to adjust an internal pressure of the emission area of the container member provided with the emission port to a pressure lower than an internal pressure of the supply area of the container member provided with the supply port.

In the molten material supply unit according to an aspect of the present disclosure, the raw material supply portion may include a raw material reservoir provided with the solid material; and a gate member connecting the raw material reservoir and the melting container portion, and configured to transfer the solid material to the melting container portion, wherein the gate member may include a gate valve provided in a lower end portion of the raw material reservoir connected to the melting container portion; and a screw mover provided between the gate valve and the melting container portion to transfer the solid material.

In the molten material supply unit according to an aspect of the present disclosure, the raw material supply portion may further include an inlet valve provided at an upper end inlet of the raw material reservoir to which the solid material is supplied; and a pressure regulating pump provided in the raw material reservoir, and configured to create a vacuum environment in an internal portion of the raw material reservoir.

According to another aspect of the present disclosure, a dry coating device includes the molten material supply unit; a vacuum chamber unit configured to move a member to be plated therethrough, and provided with the melting container portion of the molten material supply unit therein; and a gas spraying unit provided in an internal portion of the vacuum chamber unit, connected to the melting container portion, spraying a gaseous material formed by heating the liquefied material, and coating the member to be plated with the gaseous material.

In the dry coating device according to another aspect of the present disclosure, the gas spraying unit may include an evaporation container provided in an internal portion of the vacuum chamber unit; and an evaporation heater provided in the evaporation container, and heating and evaporating the liquefied material.

In the dry coating device according to another aspect of the present disclosure, the gas spraying unit may further include a connection pipe communicating with the emission port formed in the melting container portion at one end portion, extending into and connected to an internal portion of the evaporation container at the other end portion, and configured to be immersed in the liquefied material transferred from the melting container portion to the evaporation container.

In the dry coating device according to another aspect of the present disclosure, the gas spraying unit may further include a pipe heater configured to surround the connection pipe and heat the connection pipe.

### [Advantageous Effects]

According to an aspect of the present disclosure, the molten material supply unit and the dry coating device comprising the same are advantageous in that the plated material may be continuously charged without processing the plated material into a wire form or charging the plated material in a liquid form, to perform a dry plating operation.

Particularly, according to an aspect of the present disclosure, when the solid material is used, the plated material may prevent the gaseous material from flowing back to the raw material supply portion from which the solid material is supplied, wherein the gaseous material is formed, in a manner in which the solid material is formed into the liquefied material, and the liquefied material is then reheated to form the gaseous material. Therefore, it has an advantage that the solid material may be supplied in a stable and continuous manner.

### [Description of Drawings]

FIG. 1 is a front view illustrating a molten material supply unit of the present disclosure,
FIG. 2 is a front view illustrating a melting container portion in a molten material supply unit of the present disclosure,
FIG. 3 is a front view illustrating a raw material supply portion in a molten material supply unit of the present disclosure, and
FIG. 4 is a front view illustrating a dry coating device of the present disclosure.

### [Best Mode for Invention]

Hereinafter, specific embodiments of the present disclosure will be described in detail with reference to the drawings. It will be apparent to those skilled in the art that various modifications and variations may be made in the present disclosure without departing from the spirit or scope of the inventive concept as defined by the appended claims. Other embodiments falling within the scope of the inventive concept may be easily suggested, but are also included within the scope of the present disclosure.

In the following description, the same reference numerals are used to designate the same components in the same mappings shown in the drawings of the embodiments.

The present disclosure relates to a molten material supply unit 100 and a dry coating device including the same, and a plated material for performing a dry plating operation may be continuously incorporated, without processing the plated material into a wire form or charging the plated material in a liquid form.

In particular, when a solid material SM is used, the plated material may be prevented from flowing back a gaseous material GM to a raw material supply portion 110 to which the solid material SM is supplied, wherein the gaseous material GM is formed, in a way that the solid material SM is formed into a liquefied material LM, and the liquefied material LM is then reheated to form the gaseous material GM. Therefore, it has an advantage that the solid material SM may be supplied in a stable and continuous manner.

In this case, the solid material SM forming the gaseous material GM may be a metal material, such as zinc, or the like, for coating a steel sheet, or the like.

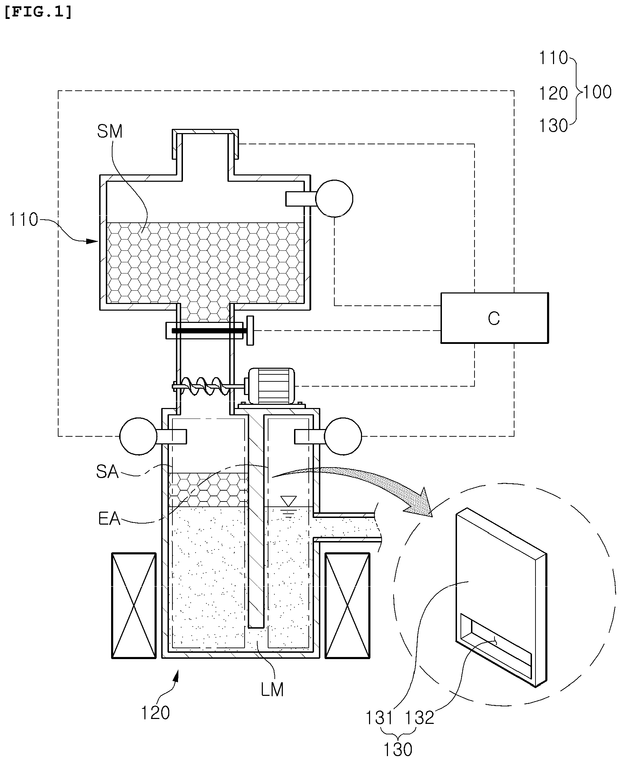

FIG. 1 is a front view illustrating a molten material supply unit 100 of the present disclosure. Referring to this, a molten material supply unit 100 according to an embodiment of the present disclosure may include a raw material supply portion 110 to which a solid material SM is supplied; a melting container portion 120 connected to the raw material supply portion 110, and configured to melt the solid material SM to form a liquefied material LM and then emit the liquefied material externally; and a barrier portion 130 provided between a supply area SA of the melting container portion 120 connected to the raw material supply portion 110 and an emission area EA of the melting container portion 120 emitting the liquefied material LM externally, and configured to move only the liquefied material LM to the emission area EA.

For example, since the barrier portion 130 may be provided, the gaseous material GM may be prevented from flowing back to the raw material supply portion 110 in which the solid material SM is stored.

In other words, when the molten material supply unit 100 is connected to a gas spraying unit 300 to be describedlater, a gaseous material GM formed in the gas spraying unit 300 may flow back to the melting container portion 120 of the molten material supply unit 100. In this case, the gaseous material GM flowing back to the melting container portion 120 may be blocked by the barrier portion 130, and thus, may not flow back to the raw material supply portion 110.

Therefore, the raw material supply portion 110 may continuously supply the solid material SM to the melting container portion 120, without a need for considering the back flow of the gaseous material GM.

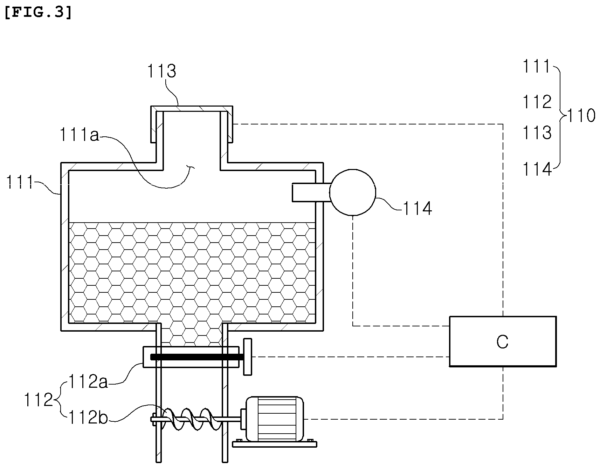

In this case, the solid material SM may be provided in the raw material supply portion 110 by storing the solid material SM, and the raw material supply portion 110 may supply the solid material SM to the melting container portion 120. For this, the raw material supply portion 110 may include a raw material reservoir 111, a gate member 112, an inlet valve 113, a pressure regulating pump 114, and the like. A detailed description thereof will be given later with reference to FIG. 3.

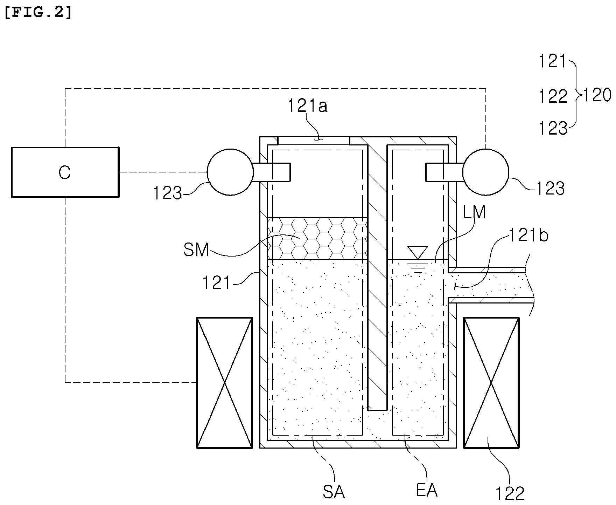

When the melting container portion 120 receives the solid material SM from the raw material supply portion 110, the melting container portion 120 may serve to heat the solid material SM to form a liquefied material LM, and emit the liquefied material LM to an external portion, such as a gas spraying unit 300, or the like. For this, the melting container portion 120 may include a container member 121, a melting heater 122, a pressure adjuster 123, and the like. A detailed description thereof will be given later with reference to FIG. 2.

The barrier portion 130 may serve to separate a supply area SA and an emission area EA of the melting container portion 120. The solid material SM supplied from the raw material supply portion 110 may be shielded from being moved from the supply area SA to the emission area EA. Therefore, an un-liquefied solid material SM, or an oxide that may be formed in the supply area SA may be prevented from being emitted externally, such as to the gas spraying unit 300, or the like, through the emission area EA.

For this, the barrier portion 130 may be provided between the supply area SA connected to the raw material supply portion 110 supplying the solid material SM and the emission area EA emitting the liquefied material LM externally. The liquefied material LM may be configured to move from the supply area SA to the emission area EA.

For example, the barrier portion 130 of the molten material supply unit 100 according to an embodiment of the present disclosure may include a wall member 131 provided between the supply area SA, one side of the melting container portion 120, and the emission area EA, the other side of the melting container portion 120, to separate an upper end portion of the supply area SA from an upper end portion of the emission area EA; and a through hole 132 provided in a lower end portion of the wall member 131.

The through hole 132 may be formed by forming a hole in a lower end portion of a plate member constituting the wall member 131. The plate member forming the wall member 131 may also be formed between the supply area SA and the emission area EA, but not at a lower end portion thereof.

FIG. 2 is a front view illustrating a melting container portion 120 in a molten material supply unit 100 of the present disclosure. Referring to this, a melting container portion 120 of a molten material supply unit 100 may include a container member 121 having a supply port 121a formed on one side of the melting container portion and connected to the raw material supply portion 110, and an emission port 121b formed on the other side of the melting container portion and emitting the liquefied material LM externally; and a melting heater 122 provided in the container member 121 and melting the solid material SM.

For example, when the melting container portion 120 receives the solid material SM from the raw material supply portion 110, the melting container portion 120 may include the container member 121, the melting heater 122, and the like, to heat the solid material SM to form a liquefied material LM, and emit the liquefied material LM to an external portion, such as a gas spraying unit 300, or the like.

In this case, the container member 121 may be configured to receive the solid material SM from the raw material supply portion 110, and may be separated into the supply area SA and the emission area EA by the barrier portion 130. The container member 121 may be provided with a supply port 121a for receiving the solid material SM from the raw material supply portion 110 and an emission port 121b for emitting the liquefied material LM to the gas spraying unit 300 or the like externally.

The container member 121 may be provided with a melting heater 122 for heating the solid material SM, and may be provided with a pressure adjuster 123 for differentially forming pressures of the supply area SA and the emission area EA, and the like.

The melting heater 122 may be configured to heat a solid material SM supplied to the container member 121 to form a liquefied material LM. For example, the melting heater 122 may be provided to heat a solid material SM using heat generated by electromagnetic induction. At this time, an electromagnetic coil, or the like, capable of applying current to a peripheral portion of the container member 121, may be provided. The electromagnetic coil, or the like, may also be connected to a controller C to control a heating temperature.

The melting heater 122 may also be configured not only by heating by an electromagnetic induction, but also by heating by a gas burner, by heating by a hot wire, or the like.

In addition, the melting container portion 120 may further include a pressure adjuster 123 to differentially form pressures of the supply area SA and the emission area EA.

For example, the melting container portion 120 of the molten material supply unit 100 may include a pressure adjuster 123 provided in the container member 121, and configured to adjust an internal pressure of the emission area EA of the container member 121 provided with the emission port 121b to a pressure lower than an internal pressure of the supply area SA of the container member 121 provided with the supply port 121a.

When the pressures of the supply area SA and the emission area EA are differentially formed by the pressure adjuster 123 as described above, a problem in which a movement of the liquefied material LM, e.g., the liquefied material LM may be evaporated in an internal portion of the container member 121, and may be released to the raw material supply portion 110, may be prevented.

In other words, when the pressure of the supply area SA is set to be higher than the pressure of the emission area EA, the liquefied material LM existing in the supply area SA may be moved to the emission area EA through the barrier portion 130 in a greater amount. In addition, when the pressure of the supply area SA is further increased, a problem that the liquefied material LM existing in the supply area SA evaporates at a relatively low pressure may be advantageously prevented.

The pressure adjuster 123 may be connected to the controller C to adjust the pressures of the supply area SA and the emission area EA.

FIG. 3 is a front view illustrating a raw material supply portion 110 in the molten material supply unit 100 of the present disclosure. Referring to this, the raw material supply portion 110 of the molten material supply unit 100 according to an embodiment of the present disclosure may include a raw material reservoir provided with the solid material SM; and a gate member 112 connecting the raw material reservoir 111 and the melting container portion 120, and configured to transfer the solid material SM to the melting container portion 120, wherein the gate member 112 may include a gate valve 112a provided in a lower end portion of the raw material reservoir 111 connected to the melting container portion 120; and a screw mover 112b provided between the gate valve 112a and the melting container portion 120 to transfer the solid material SM.

For example, the raw material supply portion 110 may include the raw material reservoir 111, the gate member 112, and the like, to supply the solid material SM to the melting container portion 120.

In this case, the raw material reservoir 111 may be configured such that the solid material SM is supplied from an external source, and is then stored, before the solid material SM is transferred to the melting container portion 120. In particular, when the melting container portion 120 is provided in a vacuum chamber, or the like, to be described later, since the solid material SM may not be smoothly supplied due to a pressure difference with external air, the raw material reservoir 111 may include an inlet valve 113, a pressure regulating pump 114, and the like.

The raw material reservoir 111 may include a gate member 112, and the like to control an amount of the solid material SM to be supplied to the melting container portion 120.

The gate member 112 may be configured to transfer the solid material SM from the raw material reservoir 111 to the melting container portion 120, in particular, to adjust an amount to deliver the solid material SM to the melting container portion 120. For this, the gate member 112 may include a gate valve 112a, a screw mover 112b, and the like.

The gate valve 112a may serve to open or close a lower end portion of the raw material reservoir 111. The gate valve 112a may be configured to be closed when an internal pressure of the raw material reservoir 111 is adjusted by a pressure regulating pump 114 or the like, to be described later, and may be configured to be open when the solid material SM is supplied to the melting container portion 120, after the internal pressure of the raw material reservoir 111 is adjusted.

When the gate valve 112a is open to supply the solid material SM from the raw material reservoir 111 to the melting container portion 120, the screw mover 112b may serve to control an amount of the solid material SM to be supplied. For example, the screw mover 112b may control an amount of the solid material SM to be supplied by an amount of a motor to be rotated, while a screw bar, having a screw shape, connected to the motor is rotated.

For this, the gate valve 112a and the screw mover 112b may be connected to the controller C, such that an opening or closing operation of the gate valve 112a or an amount of a motor to be rotated in the screw mover 112b may be adjusted.

In addition, the raw material supply portion 110 may include the inlet valve 113, the pressure regulating pump 114, and the like, to adjust an internal pressure of the raw material reservoir 111.

For example, the raw material supply portion 110 of the molten material supply unit 100 according to an embodiment of the present disclosure may include an inlet valve 113 provided in the upper end inlet 111a of the raw material reservoir 111 to which the solid material SM is supplied, and a pressure regulating pump 114 provided in the raw material reservoir 111 to create a vacuum environment in an internal portion of the raw material reservoir 111.

In this case, the inlet valve 113 may be configured to be open and closed, to supply the solid material SM from an external source to the raw material reservoir 111, and, in addition, may serve to seal the upper end inlet 111a of the raw material reservoir 111 to adjust an internal pressure of the raw material reservoir 111. For example, the inlet valve 113 may be provided as an inter-lock valve.

The pressure regulating pump 114 may serve to adjust an internal pressure of the raw material reservoir 111. For example, when the melting container portion 120 connected to the raw material reservoir 111 is provided in a vacuum chamber unit 200 to be described later, the pressure regulating pump 114 may adjust an internal pressure of the raw material reservoir 111 to prevent a problem that the liquefied material LM or the like is suddenly supplied to the gas spraying unit 300 or the like by a pressure difference with the melting container portion 120. Such a pressure regulating pump 114 may be connected to the controller C to adjust an internal pressure of the raw material reservoir 111.

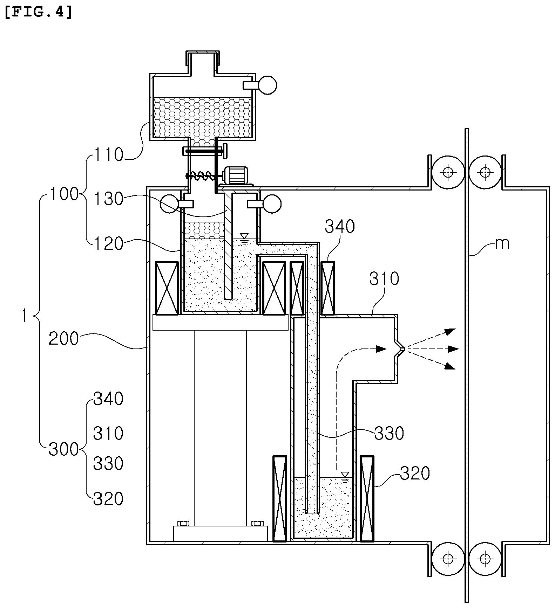

FIG. 4 is a front view illustrating a dry coating device according to the present disclosure. Referring to this, a dry coating device according to another embodiment of the present disclosure may include the molten material supply unit 100; a vacuum chamber unit 200 configured to move a member to be plated m therethrough, and provided with the melting container portion 120 of the molten material supply unit 100 therein; and a gas spraying unit 300 provided in an internal portion of the vacuum chamber unit 200, connected to the melting container portion 120, spraying a gaseous material GM formed by heating the liquefied material LM, and coating the member to be plated m with the gaseous material GM.

For example, the dry coating device may include the above-described molten material supply unit 100, and may be configured to continuously supply the solid material SM and to coat the member to be plated m with the gaseous material GM.

The vacuum chamber unit 200 may function as a body, having the gas spraying unit 300, the molten material supply unit 100, and the like, to perform a dry plating operation on the member to be plated m.

In addition, a pressure adjuster 123 and the like may be provided to form an internal vacuum environment for the dry plating operation with respect to the member to be plated m. Further, a guide roller or the like through which the member to be plated m moves may also be provided.

The gas spraying unit 300 may serve to receive a liquefied material LM from the molten material supply unit 100, heat the liquefied material LM to form a gaseous material GM, and perform a coating operation by spraying the gaseous material GM to the member to be plated m.

For this, the gas spraying unit 300 may include an evaporation container 310, an evaporation heater 320, and the like.

For example, the gas spraying unit 300 of the dry coating device according to another embodiment of the present disclosure may include an evaporation container 310 provided in an internal portion of the vacuum chamber unit 200, and an evaporation heater 320 provided in the evaporation container 310, and heating and evaporating the liquefied material LM.

The evaporation container 310 may serve to connect to the melting container portion 120 to receive the liquefied material LM, and the evaporation heater 320 may serve to heat the liquefied material LM in an internal portion of the evaporation container 310 to form a gaseous material GM.

For this, the evaporation container 310 may be provided in an internal portion of the vacuum chamber unit 200, and the evaporation heater 320 may include components for an electromagnetic induction heating operation, and the like. In this case, the evaporation heater 320 may be provided with an electromagnetic coil, or the like, capable of applying current to a peripheral portion of the evaporation container 310, to induce an electromagnetic induction heating operation of the liquefied material LM. The electromagnetic coil, or the like, may be connected to the controller C to control a heating temperature.

The evaporation heater 320 may be configured not only by heating by an electromagnetic induction, but also by heating by a gas burner, by heating by a hot wire, or the like.

The evaporation container 310 may be provided with an spray nozzle in a direction toward the member to be plated m, to spray the gaseous material GM formed by the evaporation heater to the member to be plated m.

The gas spraying unit 300 may include a connection pipe 330 and a pipe heater 340 to connect the evaporation container 310 and the melting container portion 120.

For example, a gas spraying unit 300 of the dry coating device according to another embodiment of the present disclosure may further include a connection pipe 330 communicating with the emission port 121b formed in the melting container portion 120 at one end portion, extending into and connected to an internal portion of the evaporation container 310 at the other end portion, and configured to be immersed in the liquefied material LM transferred from the melting container portion 120 to the evaporation container 310.

In addition, the gas spraying unit 300 of the dry coating device according to another embodiment of the present disclosure may further include a pipe heater 340 configured to surround the connection pipe 330 and heat the connection pipe 330.

In this case, the connection pipe 330 may connect the melting container portion 120 and the evaporation container 310, and may communicate with the emission port 121b of the melting container portion 120 at one end portion, and may be immersed in an internal portion of the liquefied material LM of the evaporation container 310 at the other end portion, to prevent the gaseous material GM formed in an internal portion of the evaporation container 310 from flowing back to the melting container portion 120.

In addition, the connection pipe 330 may be connected to the melting container portion 120 provided in a position higher than a position of the evaporation container 310, to transfer the liquefied material LM from the melting container portion 120 to the evaporation container 310.

The connection pipe 330 may be provided with a pipe heater 340 to prevent the liquefied material LM from solidifying during a transfer of the liquefied material LM.

In this case, the pipe heater 340 may be provided in a configuration using heat generated by electromagnetic induction, and may be provided with an electromagnetic coil, or the like, capable of applying a current to a peripheral portion of the coupling pipe 330, such that the pipe heater 340 heats the liquefied material LM in an internal portion of the connection pipe 330. The electromagnetic coil, or the like, may be connected to the controller C to control a heating temperature.

The pipe heater 340 may also be configured not only by heating by an electromagnetic induction, but also by heating by a gas burner, by heating by a hot wire, or the like.

While exemplary embodiments have been shown and described above, it will be apparent to those skilled in the art that modifications and variations could be made without departing from the scope of the present disclosure as defined by the appended claims.

## Claims

1. A molten material supply unit comprising:
a raw material supply portion to which a solid material is supplied;
a melting container portion connected to the raw material supply portion, and configured to melt the solid material to form a liquefied material and then emit the liquefied material externally; and
a barrier portion provided between a supply area of the melting container portion connected to the raw material supply portion and an emission area of the melting container portion emitting the liquefied material externally, and configured to move only the liquefied material to the emission area.

2. The molten material supply unit according to claim 1,
wherein the barrier portion comprises:
a wall member provided between the supply area, one side of the melting container portion, and the emission area, the other side of the melting container portion, to separate an upper end portion of the supply area from an upper end portion of the emission area; and
a through hole provided in a lower end portion of the wall member.

3. The molten material supply unit according to claim 1,
wherein the melting container portion comprises:
a container member having a supply port formed on one side of the melting container portion and connected to the raw material supply portion, and an emission port formed on the other side of the melting container portion and emitting the liquefied material externally; and
a melting heater provided in the container member and melting the solid material.

4. The molten material supply unit according to claim 3,
wherein the melting container portion further comprises:
a pressure adjuster provided in the container member, and configured to adjust an internal pressure of the emission area of the container member provided with the emission port to a pressure lower than an internal pressure of the supply area of the container member provided with the supply port.

5. The molten material supply unit according to claim 1,
wherein the raw material supply portion comprises:
a raw material reservoir provided with the solid material; and
a gate member connecting the raw material reservoir and the melting container portion, and configured to transfer the solid material to the melting container portion,
wherein the gate member comprises:
a gate valve provided in a lower end portion of the raw material reservoir connected to the melting container portion; and
a screw mover provided between the gate valve and the melting container portion to transfer the solid material.

6. The molten material supply unit according to claim 5,
wherein the raw material supply portion further comprises:
an inlet valve provided at an upper end inlet of the raw material reservoir to which the solid material is supplied; and
a pressure regulating pump provided in the raw material reservoir, and configured to create a vacuum environment in an internal portion of the raw material reservoir.

7. A dry coating device comprising:
the molten material supply unit according to any one of claims 1 to 6;
a vacuum chamber unit configured to move a member to be plated therethrough, and provided with the melting container portion of the molten material supply unit therein; and
a gas spraying unit provided in an internal portion of the vacuum chamber unit, connected to the melting container portion, spraying a gaseous material formed by heating the liquefied material, and coating the member to be plated with the gaseous material.

8. The dry coating device according to claim 7,
wherein the gas spraying unit comprises:
an evaporation container provided in an internal portion of the vacuum chamber unit; and
an evaporation heater provided in the evaporation container, and heating and evaporating the liquefied material.

9. The dry coating device according to claim 8,
wherein the gas spraying unit further comprises:
a connection pipe communicating with the emission port formed in the melting container portion at one end portion, extending into and connected to an internal portion of the evaporation container at the other end portion, and configured to be immersed in the liquefied material transferred from the melting container portion to the evaporation container.

10. The dry coating device according to claim 9,
wherein the gas spraying unit further comprises:
a pipe heater configured to surround the connection pipe and heat the connection pipe.
